Europäisches Patentamt

(19) European Patent Office

Office européen des brevets

(11) Numéro de publication: **0 250 474**
**B1**

(12) **FASCICULE DE BREVET EUROPEEN**

(45) Date de publication du fascicule du brevet: **30.01.91**

(51) Int. Cl.⁵: **H 03 H 3/08**

(21) Numéro de dépôt: **86906856.9**

(22) Date de dépôt: **25.11.86**

(86) Numéro de dépôt international:
**PCT/FR86/00402**

(87) Numéro de publication internationale:
**WO 87/03756 18.06.87 Gazette 87/13**

(54) **PROCEDE DE FABRICATION D'UN FILTRE DISPERSIF A ONDES DE SURFACE ET FILTRE FABRIQUE SELON CE PROCEDE.**

(30) Priorité: **04.12.85 FR 8517947**

(43) Date de publication de la demande:
**07.01.88 Bulletin 88/01**

(45) Mention de la délivrance du brevet:
**30.01.91 Bulletin 91/05**

(84) Etats contractants désignés:
**DE IT**

(56) Documents cités:
**US-A-4 460 995**

**Electronic Engineering,vol.49,No.592,May 1977 (London,GB),J.M.Autran et al.:"Application of cad techniques to saw filters",pages 51-54,see the whole document**

**IEE Proceedings,vol.131,No.4,part A,June 1984 (Old Woking,Surrey,GB)M.F.Lewis et al.:"Recent developments in SAW devices",see figures 4,11-14;pages 194-195:"Weighting methods";figure 27;pages 202-203:"Reflective array compressor (RAC)";figure 10;page 193:"Multistrip couplers"**

(73) Titulaire: **THOMSON-CSF**
**51, Esplanade du Général de Gaulle**
**F-92800 Puteaux (FR)**

(72) Inventeur: **GAUTIER, Hervé**
**550, chemin des Combes**
**F-06600 Antibes (FR)**
Inventeur: **LARDAT, Claude**
**26, lotissement de Puidamonte**
**F-06330 Rocquefort les Pins (FR)**

(74) Mandataire: **Desperrier, Jean-Louis et al**
**THOMSON-CSF SCPI**
**F-92045 PARIS LA DEFENSE CEDEX 67 (FR)**

Courier Press, Leamington Spa, England.

Description

La présente invention se rapporte aux procédés de fabrication des filtres dispersifs à ondes de surface dans lesquels on utilise la rléflexion des ondes acoustiques sur des réseaux à pas variables inclinés par rapport à la direction de propagation de ces ondes acoustiques.

Ces filtres sont connus sous le nom générique de RAC correspondant à l'abréviation de la dénomination anglo-saxonne "Reflective Array Compressors". Le produit bande passante par durée de signal, dit BT, de ces filtres est très important, ce qui en fait l'intérêt.

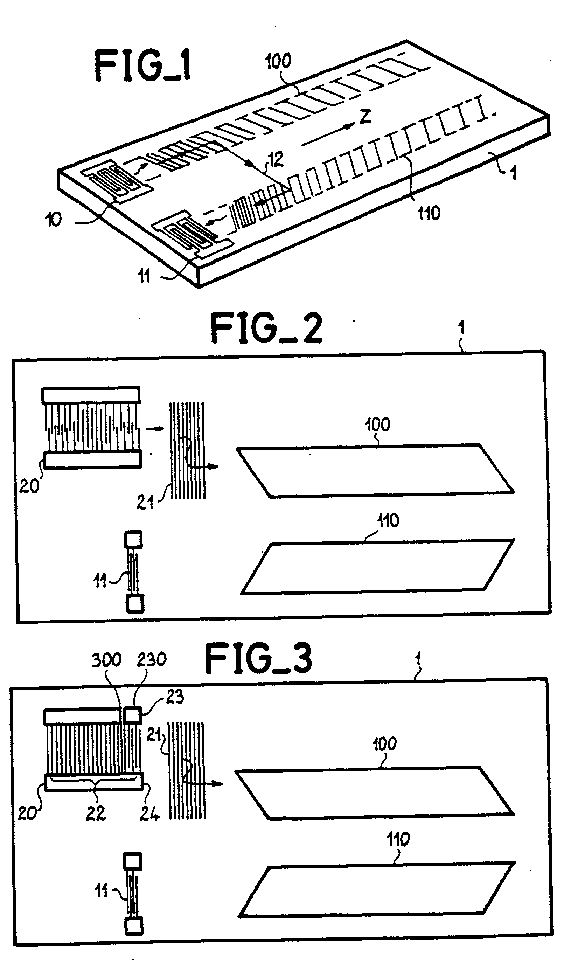

Un RAC correspondant à l'état de l'art est représenté sur la figure 1, voir aussi l'article publié dans IEE, Proceedings, vol. 131, no 4, partie A, juin 1984 (Old Woking, Surrey, GB) M. F. Lewis et al.: "Recent developments in SAW devices". Il comporte sur un substrat piézoélectrique 1 un transducteur interdigité d'émission 10 qui, à partir du signal à comprimer, envoie une onde acoustique dans la direction d'un premier réseau réfléchissant 100. Ce réseau comporte une série de discontinuités en forme de traits inclinés sensiblement à 45° par rapport à l'axe de propagation Z de l'onde acoustique. Ces discontinuités, ainsi que le transducteur 10 et le transducteur 11 dont on va parler plus loin, sont formées par des gravures ou des métallisations sur la surface du substrat.

L'onde acoustique est réfléchie par le réseau 100 sensiblement à 90° vers un deuxième réseau 110 identique au premier mais symétrique par rapport à l'axe Z. L'onde acoustique se réfléchit alors sensiblement à 90° sur ce deuxième réseau pour repartir dans la direction opposée à l'axe Z.

Elle est alors recueillie par un transducteur de sortie 11 qu'elle excite pour donner un signal électrique de sortie.

L'espacement des discontinuités dans les deux réseaux réfléchissants est variable en fonction de la distance aux transducteurs d'entrée et de sortie. De cette manière le pouvoir réflecteur est variable avec la fréquence et selon cette fréquence l'onde acoustique parcourera un trajet tel que 12 dont la longueur, et donc la durée, dépendra de la fréquence.

La fonction de transfert globale de ce dispositif correspond au produit des fonctions de transfert des transducteurs d'entrée et de sortie et des réseaux réfléchissants et provoque une compression de l'impulsion appliquée sur le transducteur d'entrée.

Un tel dispositif, par suite de différents phénomènes parasites, ne donne par directement la réponse en amplitude et en phase exactement souhaitée dans la bande utile.

Pour corriger les défauts d'amplitude et de phase, il est connu de corriger la réponse du RAC à l'aide d'un filtre électrique classique, du type RLC, mis en série avec ce RAC. On mesure la fonction de transfert du RAC et à partir de celle-ci on synthétise selon des methodes connues un filtre ayant une fonction de transfert permettant de corriger celle du RAC.

On rajoute alors au niveau du filtre de correction des inconvénients connus tels que, perte d'insertion, encombrement et influence des différentes dérives, notamment en température.

Il par ailleurs connu, mais uniquement en ce qui concerne l'erreur de phase, de corriger celle-ci en déposant entre les deux réseaux réfléchissants 100 et 110 un film conducteur de largeur et d'épaisseur variables pour modifier la vitesse de propagation pour chaque trajet des ondes et donc pour chaque fréquence. Ce procédé ne permet pas toutefois de bien corriger les fluctuations d'erreurs rapides.

L'invention propose d'utiliser dans un tel RAC un transducteur d'entrée ou de sortie conçu pour avoir une fonction de transfert qui corrige les défauts du RAC.

Selon une caractéristique particulière de l'invention, telle que définie dans les revendications indépendantes 1, 2 et 3, on fabrique tout d'abord le RAC avec des transducteurs d'entrée et de sortie ordinaires, on mesure sa fonction de transfert, puis on remplace au moins l'un de ces transducteurs par un transducteur calculé pour corriger cette fonction de transfert.

D'autres particularités et avantages de l'invention apparaîtront clairement dans la description suivante faite en regard des figures annexées qui représentent:

—la figure 1, un filtre RAC selon l'art connu;

—la figure 2, un filtre RAC selon l'invention;

—les figures 3, 4, 5, 7 des variantes de réalisation d'un filtre RAC selon l'invention;

—la figure 6, une variante du transducteur 20 de ces filtres RAC.

Le filtre dispersif de type RAC selon l'invention, représenté sur la figure 2 porte sur un substrat 1 deux réseaux réfléchissants 100 et 110, représentés ici de manière schématique, et un transducteur de sortie 11. Ces éléments sont identiques à ceux des RAC connus.

Le transducteur d'entrée 20 quant à lui, est formé de deux peignes interdigités dont le nombre de dents et les longueurs de recouvrement inégales de ces dents permettent d'obtenir une fonction de transfert déterminée et calculée à l'avance. La méthode de synthèse d'un tel transducteur est bien connue du brevet français 2.040.881.

Comme toutefois le champ acoustique produit par un tel transducteur n'est pas homogène, puisque les ondes sonores traversent des zones plus ou moins métallisées, il est préférable, pour obtenir un front d'onde incident uniforme qui n'affecte pas la réponse des réflecteurs du réseau 100 et 110, d'utiliser un coupleur 21 dont les advantages sont connus dans l'art.

La fonction de transfert du transducteur 20 et du coupleur 21 est calculée pour compenser les erreurs de phase et d'amplitude du reste du RAC. Pour déterminer cette fonction de transfert et calculer la géométrie du transducteur 20 en conséquence, on utilise un procédé dont les étapes sont les suivantes:

On fabrique tout d'abord un RAC classique, tel

2

que représenté en figure 1, sur un substrat suffisamment long pour pouvoir implanter ensuite le transducteur 20 et le coupleur 21.

On mesure ensuite la fonction de transfert $H_M(f)$ du filtre, aussi bien en amplitude qu'en phase.

On calcule ensuite la fonction de transfert $H_E(f)$ du transducteur d'entrée provisoire. Ce calcul peut s'effectuer par la même méthode que cell qui permettra de synthétiser le transducteur 20 puisque la structure du transducteur 10 est de même nature mais extrêmement simplifié car il comporte très peu de dents et le recouvrement de celles-ci est constant.

On calcule alors, à partir de la fonction de transfert sans erreurs à obtenir $H_c(f)$, la fonction de transfert $H(f)$ du transducteur de correction d'entrée 20 par la formule:

$$H(f) = H_E(f) \times \frac{H_c(f)}{H_M(f)}$$

On détermine ensuite la géométrie du transducteur 20 par un procédé de synthèse connu. Ce procédé met en oeuvre un programme de calcul qui synthétise les transducteurs, à partir d'une fonction de transfert donnée, de façon qu'une fois réalisés ils présentent des erreurs inférieures aux erreurs à corriger. Ce programme prend en compte l'influence du coupleur.

Dans une dernière étape, on remplace enfin le transducteur d'entrée provisoire par le transducteur de correction définitif 20. Pour cela on peut par exemple procéder à une attaque chimique sélective du transducteur provisoire puis fabriquer le transducteur définitif par dépôt métallique sous vide.

De multiples variantes sont possibles à partir de ce schéma de base.

En premier lieu, il est toujours possible de remplacer le transducteur de sortie au lieu du transducteur d'entrée par un transducteur de correction, et même de remplacer le transducteur d'entrée et le transducteur de sortie chacun par un transducteur de correction qui prennent chacun en compte une partie de la correction à apporter.

Sur une autre variante représentée en figure 3, on a fabriqué pour les mesures un RAC comportant déjà le coupleur 21 et le transducteur d'entrée 20. Toutefois dans ce transducteur d'entrée 20 seuls les quatre dents les plus proches du coupleur 21 sont isolées des deux électrodes d'alimentation 23 et 24 et sont de longueurs constantes réalisant ainsi le transducteur provisoire. L'ensemble des autres dents 22 est raccordé des deux côtés aux électrodes 23 et 24 et ces dents sont ainsi inactives. L'électrode 23 est coupée en 300 pour éviter le court-circuit. Le transducteur provisoire est alimenté par les électrodes 230 et 24.

Quand on a alors déterminé la longueur à donner aux différentes dents pour obtenir un RAC corrigé, il suffit d'enlever une partie adéquate des dents, par exemple par usinage avec un laser. Les deux côtés de l'électrode 23 sont alors connectés.

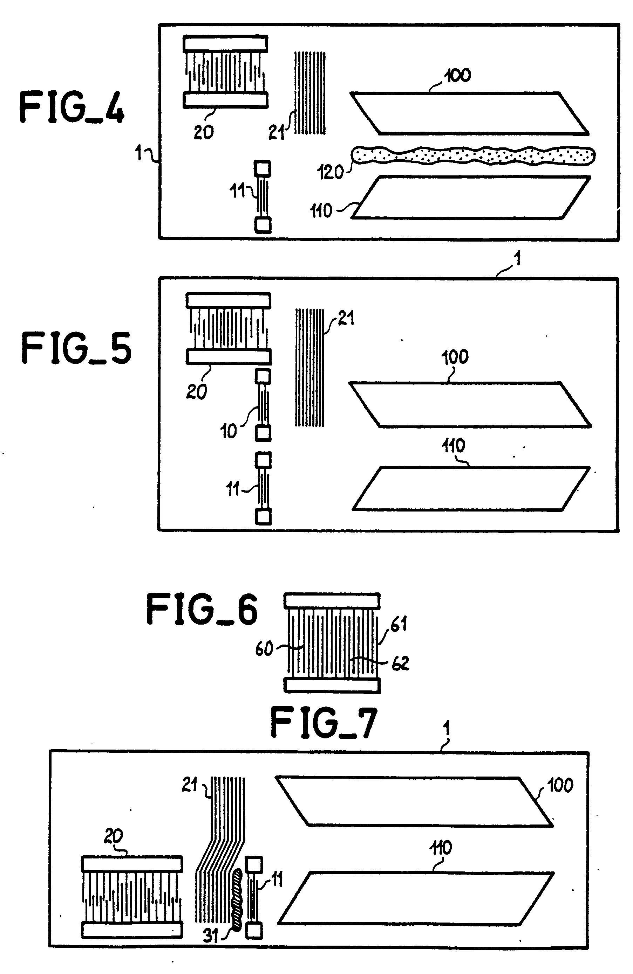

Dans une autre variante de réalisation, représentée en figure 4, on utilise pour corriger les erreurs de phase un film conducteur 120 déposé entre les deux réseaux 100 et 110. Le transducteur d'entrée 20 est alors calculé uniquement pour corriger les erreurs d'amplitude, ce qui simplifie sa réalisation. Par contre, les fluctuations d'erreurs rapides de phase sont moins bien corrigées.

Il est aussi possible d'éviter l'emploi du coupleur 21 en n'utilisant pas dans le transducteur 20 la pondération par la longueur des dents, mais une pondération par un procédé qui assure que l'onde acoustique produite a un front d'onde uniforme. On peut employer pour cela plusieurs techniques telle que celle par tout ou rien (en Anglais withdrawal), ou par couplage capacitif.

Un exemple de transducteur pondéré par tout ou rien est représenté sur la figure 6, où l'on voit que le recouvrement de longueur entre les dents est partout le même et que l'on à créé en supprimant certains dents des sources à amplitude nulle telle que 60, à amplitude −1 telle que 61 et à amplitude +1 telle que 62.

Un autre procédé pour éviter d'avoir à tenir compte dans le calcul de l'influence du coupleur 21 consiste, comme représenté sur la figure 5, à utiliser un coupleur dont la longueur soit suffisante pour que le transducteur de correction 20 soit situé entièrement en dehors de la face frontale du réseau 100. On peut alors implanter le transducteur de mesure 10 en face de cette face frontale et du même côté du coupleur 21 que le transducteur de correction 20. Ceci permet de réaliser ces deux transducteurs en même temps, et en fait en même temps que le coupleur 21, que les réseaux 100 et 110, et que le transducteur de sortie 11, dans une seule opération de métallisation. On utilise alors le transducteur 10 pour effectuer la mesure de la fonction de transfert du reste du RAC, y compris le coupleur 21, et compte tenu des résultats de cette mesure on ajuste le transducteur 20 par usinage laser par exemple. Le RAC corrigé est alors prêt et il suffit de relier les connections d'entrée au transducteur 20 en laissant inutilisé le transducteur 10 sans que celui-ci ait besoin d'être enlevé de la surface du substrat 1.

On peut aussi prévoir d'implanter dès l'origine le coupleur 21. Dans la synthèse du transducteur de correction, l'influence du coupleur n'est alors plus à prendre en compte.

Une autre variante permet enfin d'éviter d'augmenter la largeur du substrat au prix d'une augmentation de sa longueur, ce qui est parfois préférable compte tenu des méthodes de fabrication des substrats. Pour cela, comme représenté sur la figure 7, on implante le transducteur de correction 20 vers le bas du substrat du côté du réseau 110. Le coupleur 21 est alors réalisé de manière connue pour ramener les ondes acoustiques vers le réseau 100.

Pour éviter alors que la partie des ondes acoustiques qui traverse le transducteur de réception 11 vienne perturber aussi bien le transducteur 20 que le réseau 100 via le coupleur 21, on dépose sur le substrat 1 entre le transducteur 11 et le coupleur 21, une couche de matière absorbante 31, selon une technique connue.

Un tel procédé permet de réaliser un filtre dispersif de type RAC avec une caractéristique en amplitude contrôlée à 0,5 décibel près. Comme les erreurs d'amplitude relevées sur les RAC réalisées de manière connue auparavant peuvent atteindre 4 décibels, l'invention permet donc d'améliorer la précision du RAC dans un facteur proche de 10.

**Revendications**

1. Procédé de fabrication d'un filtre dispersif à ondes de surface du type comprenant sur un substrat (1), un transducteur d'entrée (10) pour émettre sur la surface du substrat une onde acoustqique, un transducteur de sortie (11) pour recevoir ces ondes, et des moyens dispersifs (100), (110) situés sur le trajet des ondes pour modifier la durée du parcours de celle-ci entre les deux transducteurs en fonction de leur fréquence, comprenant les étapes de:
—fabrication d'un filtre dispersif non corrigé dont l'un au moins des transducteurs d'entrée (10) et de sortie (11) a une fonction de transfert connue;
—mesure de la fonction de transfert de ce filtre; caractérisé en ce qu'il comprend les étapes suivantes:
—synthèse d'un transducteur de correction (20) présentant une fonction de transfert permettant de corriger la fonction de transfert de ce filtre;
—implantation sur le substrat du transducteur de correction pour remplacer le transducteur (10, 11) ayant une fonction de transfert connue; celui-ci restant en place sur le substrat;
—implantation sur le substrat entre le transducteur de correction (20) et les moyens de dispersion (100, 110) d'un coupleur (21) permettant d'homogénéiser les ondes acoustiques; ce coupleur étant d'une taille suffisante pour permettre d'implanter le transducteur de correction tout en laissant sur le substrat le transducteur qu'il remplace.

2. Procédé de fabrication d'un filtre dispersif à ondes de surface du type comprenant sur un substrat (1), un transducteur d'entrée (10) pour émettre sur la surface du substrat une onde acoustique, un transducteur de sortie (11) pour recevoir ces ondes, et des moyens dispersifs (100), (110) situés sur le trajet des ondes pour modifier la durée du parcours de celle-ci entre les deux transducteurs en fonction de leur fréquence, comprenant les étapes de:
—fabrication d'un filtre dispersif non corrigé dont l'un au moins des transducteurs d'entrée (10) et de sortie (11) a une fonction de transfert connue;
—mesure de la fonction de transfert de ce filtre; caractérisé en ce qu'il comprend les étapes suivantes:
—synthèse d'un transducteur de correction (20) présentant une fonction de transfert permettant de corriger la fonction de transfert de ce filtre;
—suppression par attaque chimique sélective du transducteur ayant une fonction de transfert connue;
—implantation à la place de celui-ci du transducteur de correction.

3. Procédé de fabrication d'un filtre dispersif à ondes de surface du type comprenant sur un substrat (1), un transducteur d'entrée (10) pour émettre sur la surface du substrat une onde acoustique, un transducteur de sortie (11) pour recevoir ces ondes, et des moyens dispersifs (100), (110) situés sur le trajet des ondes pour modifier la durée du parcours de celle-ci entre les deux transducteurs en fonction de leur fréquence, comprenant les étapes de:
—fabrication d'un filtre dispersif non corrigé dont l'un au moins des transducteurs d'entrée (10) et de sortie (11) a une fonction de transfert connue;
—mesure de la fonction de transfert de ce filtre; caractérisé en ce que le transducteur (10, 11) ayant une fonction de transfert connue présente une structure en forme de peignes interdigités dont la plus grande partie (22) des dents sont courts-circuitées entre les électrodes d'accès (23, 24) du transducteurs et en ce qu'il comprend les étapes suivantes:
—synthèse d'un transducteur de correction (20) présentant une fonction de transfert permettant de corriger la fonction de transfert de ce filtre;
—modification du transducteur ayant une fonction de transfert connue par section des dents à la longueur déterminée lors de l'étape de synthèse pour obtenir ainsi le transducteur de correction.

4. Procédé selon l'une quelconque des revendications 1 à 3, caractérisé en ce que l'on synthétise un transducteur de correction (20) permettant d'obtenir une onde acoustique homogène.

5. Procédé selon la revendication 4, caractérisé en ce que cette synthèse est faite par pondération par tout ou rien d'un transducteur à dents interdigités (60—62).

6. Procédé selon l'une quelconque des revendications 1 à 5, caractérisé en ce que l'on corrige au moins partiellement les erreurs de phase en déposant sur la surface du substrat (1) et sur le trajet des ondes acoustiques entre les moyens dispersifs (100, 110) une couche conductrice (120).

7. Procédé selon l'une quelconque des revendications 1 à 6, caractérisé en ce que les deux transducteurs initiaux d'entrée (10) et de sortie (11) sont une fonction de transfert connue et que l'on substitue à chacun de ces transducteurs un transducteur de correction (20); le produit des fonctions de transfert de ces deux transducteurs de correction permettant de corriger la fonction de transfert du filtre.

**Patentansprüche**

1. Verfahren zur Herstellung eines dispersiven Oberflächenwellen-Filters eines Typs, der auf einem Substrat (1) einen Eingangswandler (10) zum Ausstrahlen einer Schallwelle an die Substratoberfläche, einen Ausgangswandler (11) zum Empfangen dieser Wellen und Streumittel (100), (110), die in der Bahn der Wellen angeordnet sind, um deren Durchlaufdauer zwischen den beiden Wandlern in Abhängigkeit von ihrer Frequenz abzuwandeln, umfaßt, mit den Schritten:

—des Herstellens eines nicht korrigierten, dispersiven Filters, von dem wenigstens entweder der Eingangswandler (10) oder der Ausgangswandler (11) eine bekannte Übertragungsfunktion besitzt; und

—des Messens der Übertragungsfunktion dieses Filters; dadurch gekennzeichnet, daß es die folgenden Schritte Umfaßt:

—Aufbau eines Korrekturwandlers (20), der eine Übertragungsfunktion aufweist, die die Korrektur der Übertragungsfunktion dieses Filters gestattet;

—Implantierung des Korrekturwandlers auf dem Substrat, um den eine bekannte Übertragungsfunktion besitzenden Wandler (10, 11) der an seinem Ort auf dem Substrat verbleibt, zu ersetzen; und

—Implantierung eines Kopplers (21) auf dem Substrat zwischen dem Korrekturwandler (20) und den Streumitteln (100, 110), der die Homogenisierung der Schallwellen gestattet und der eine Größe besitzt, die ausreicht, um die Implantierung des Korrekturwandlers zu gestatten, wenn der Wandler, den dieser ersetzt, auf dem Substrat gelassen wird.

2. Verfahren zur Herstellung eines dispersiven Oberflächenwellen-Filters eines Typs, der auf einem Substrat (1) einen Eingangswandler (10) zum Ausstrahlen einer Schallwelle an die Substratoberfläche, einen Ausgangswandler (11) zum Empfangen dieser Wellen und Streumittel (100), (110), die in der Bahn der Wellen angeordnet sind, um deren Durchlaufdauer zwischen den zwei Wandlern in Abhängigkeit ihrer Frequenz abzuwandeln, umfaßt, mit den Schritten:

—des Herstellens eines nicht korrigierten, dispersiven Filters, von dem wenigstens entweder der Eingangswandler (10) oder der Ausgangswandler (11) eine bekannte Übertragungsfunktion besitzt; und

—des Messens der Übertragungsfunktion dieses Filters; dadurch gekennzeichnet, daß es die folgenden Schritte umfaßt:

—Aufbau eines Korrekturwandlers (20), der eine Übertragungsfunktion aufweist, die die Korrektur der Übertragungsfunktion dieses Filters gestattet;

—selektives Fortätzen des eine bekannte Übertragungsfunktion aufweisenden Wandlers; und

—Implantierung des Korrekturwandlers an dessen Stelle.

3. Verfahren zur Herstellung eines dispersiven Oberflächenwellen-Filters eines Typs, der auf einem Substrat (1) einen Eingangswandler (10) zum Ausstrahlen einer Schallwelle an die Substratoberfläche, einen Ausgangswandler (11) zum Empfangen dieser Wellen und Streumittel (100), (110), die in der Bahn der Wellen angeordnet sind, um deren Durchlaufzeit zwischen den zwei Wandlern in Abhängigkeit ihrer Frequenz abzuwandeln, umfaßt, mit den Schritten:

—der Herstellung eines nicht korrigierten, dispersiven Filters, von dem wenigsetns entweder der Eingangswandler (10) oder der Ausgangswandler (11) eine bekannte Übertragungsfunktion besitzt; und

—des Messens der Übertragungsfunktion dieses Filters; dadurch gekennzeichnet, daß der die bekannte Übertragungsfunktion besitzende Wandler (10, 11) eine aus Interdigitalkämmen gebildete Struktur besitzt, von denen der größte Teil (22) der Zähne zwischen den Anschlußelektroden (23, 24) der Wandler kurzgeschlossen ist, und daß es die folgenden Schritte umfaßt:

—Aufbau eines Korrekturwandlers (20), der eine Übertragungsfunktion aufweist, der die Korrektur der Übertragungsfunktion dieses Filters gestattet; und

—Abwandlung des eine bekannte Übertragungsfunktion besitzenden Wandlers durch die Trennung der Zähne bei einer bestimmten Länge während des Aufbauschrittes, um so den Korrekturwandler zu erhalten.

4. Verfahren gemäß einem der Ansprüche 1 bis 3, dadurch gekennzeichnet, daß ein Korrekturwandler (20) aufgebaut wird, der den Erhalt einer homogenen Schallwelle gestattet.

5. Verfahren gemäß Anspruch 4, dadurch gekennzeichnet, daß dieser Aufbau durch die Gewichtung eines Wandlers mit Interdigitalzähnen (60 bis 62) mit 100% oder 0% ausgeführt wird.

6. Verfahren gemäß einem der Ansprüche 1 bis 5, dadurch gekennzeichnet, daß die Phasenfehler wenigstens teilweise korrigiert werden, indem auf der Oberfläche des Substrats (1) und in der Bahn der Schallwellen zwischen den Streumitteln (100, 110) eine leitende Schicht (120) angeordnet wird.

7. Verfahren gemäß einem der Ansprüche 1 bis 6, dadurch gekennzeichnet, daß der anfängliche Eingangswandler (10) und der anfängliche Ausgangswandler (11) jeweils eine bekannte Übertragungsfunktion besitzen und daß jeder dieser Wandler durch einen Korrekturwandler (20) ersetzt wird, wobei das Produkt der Übertragungsfunktionen dieser beiden Korrekturwandler die Korrektur der Übertragungsfunktion des Filters gestattet.

**Claims**

1. A method for the production of a surface wave dispersive filter of the type comprising, placed on a substrate (1), an input transducer (10) in order to emit an acoustic wave on the surface of the substrate, an output transducer (11) in order to receive such waves, and dispersive means (100) and (110) situated on the trajectory of the waves in order to modify the duration of the transit of the same between the two transducers as a function of the frequency thereof, comprising the stages of:

—manufacture of a non-corrected dispersive filter of which at least one of the input and output transducers (10) and (11) has a known transfer function and

—measurement of the transfer function of the filter, characterized in that it comprises the following steps:

—synthesis of a correction transducer (20) presenting a transfer function making it possible to correct the transfer function of the said filter,

—implantation on the substrate of a correction transducer in order to replace the transducer (10 and 11) having a known transfer function, the latter remaining in place on the substrate and

—implantation on the substrate between the correction transducers (20) and the dispersion means (100 and 110) of a coupler (21) making possible the homogenization of the acoustic waves, said coupler being of a sufficient size in order to make possible the implantation of the correction transducer while leaving the transducer replaced by it in place.

2. A method for the production of a surface wave dispersive filter of the type comprising, placed on a substrate (1), an input transducer (10) in order to emit an acoustic wave on the surface of the substrate, an output transducer (11) in order to receive such waves, and dispersive means (100) and (110) situated on the trajectory of the waves in order to modify the duration of the transit of the same between the two transducers as a function of the frequency thereof, comprising the stages of:

—manufacture of a non-corrected dispersive filter of which at least one of the input and output transducers (10) and (11) has a known transfer function and

—measurement of the transfer function of the filter, characterized in that it comprises the following steps:

—synthesis of a correction transducer (20) presenting a transfer function making it possible to correct the transfer function of the said filter,

—selective chemical attack to remove the transducer having a known transfer function, and

—implantation of the correction transducer in place thereof.

3. A method for the production of a surface wave dispersive filter of the type comprising, placed on a substrate (1), an input transducer (10) in order to emit an acoustic wave on the surface of the substrate, an output transducer (11) in order to receive such waves, and dispersive means (100) and (110) situated on the trajectory of the waves in order to modify the duration of the transit of the same between the two transducers as a function of the frequency thereof, comprising the stages:

—manufacture of a non-corrected dispersive filter of which at least one of the input and output transducers (10) and (11) has a known transfer function and

—measurement of the transfer function of the filter, characterized in that the transducers (10 and 11) having a known transfer function presents a structure in the form of interfitting combs of which the major part (22) of the teeth are short circuited between the access electrodes (23 and 24) of the transducers and in that it comprises the following steps:

—synthesis of a correction transducer (20) presenting a transfer function making it possible to correct the transfer function of the said filter,

—modification of the transducer having the known transfer function by cutting teeth to the determined length at the time of the synthesis stage in order to obtain the correction transducer in this manner.

4. The method as claimed in any one of the preceding claims 1 through 3, characterized in that a correction transducer (20) is synthesized making it possible to obtain a homogeneous acoustic wave.

5. The method as claimed in claim 4, characterized in that said synthesis is performed by weighting a transducer (60 through 62) with interfitting teeth with all or nothing.

6. The method as claimed in any one of the preceding claims 1 through 5, characterized in that phase errors are at least partly corrected by placing a conductive layer (120) on the surface of the substrate (1) and on the trajectory of the acoustic waves between the dispersive means (100 and 110).

7. The method as claimed in any one of the preceding claims 1 through 6, characterized in that the two initial input and output transducers (10 and, respectively, 11) have a known transfer function and in that for each of said transducers a correction transducer (20) is substituted, the product of the transfer functions of these two correction transducers making it possible to correct the transfer function of the filter.

FIG_1

FIG_2

FIG_3

FIG_4

100

120

110

20    21    11    1

FIG_5

1

21

100

20    10    11    110

FIG_6

60    61    62

FIG_7

1

21    20    31    11    100    110